# EUROPEAN PATENT APPLICATION

(11) **EP 2 026 166 A1**
(43) Date of publication of application: **18.02.2009**
(21) Application number: 07739658.8
(22) Date of filing: 26.03.2007
(51) Int. Cl.: G06F 3/02, H01H 25/04

(54) **MULTI-DIRECTION INPUT DEVICE**

(30) Priority: 06.06.2006 JP 2006157912
(71) Applicant: SUNARROW LTD., Chuo-ku, Tokyo 104-0032 (JP)
(72) Inventor: UOTANI, Toshiaki, Mitsuke-shi, Niigata 954-0076 (JP)
(74) Representative: Prinz & Partner
(86) International application number: PCT/JP2007/056220
(87) International publication number: WO 2007/141950

(57) **Abstract**

An object is to provide a multidirectional input device capable of detecting an arbitrary direction of depression before the generation of the feeling of click to depress a directional key in the arbitrary direction with a predetermined small force based on the feeling of click.

The present invention is the multidirectional input device being formed into a structure in which the directional key tilts together with the center key with the depression of the directional key in an arbitrary direction, and in which the click feeling generating section is deformed by the presser member to generate the feeling of click, as the directional key is depressed in the arbitrary direction, the multidirectional input device further comprising: a movable element and a fixed element configured so that a distance between the movable element and the fixed element changes with the depression of the directional key in the arbitrary direction at least before the generation of the feeling of click and so that the arbitrary direction of the depression is detected from the change of the distance at least before the generation of the feeling of click.

## Description

### BACKGROUND OF THE INVENTION

### Field of the Invention

The present invention relates to a multidirectional input device which is usable in electronic devices such as a cellular phone (including a so-called PHS), a portable information terminal (a personal digital assistance: PDA or the like), a portable audio device, a remote controller for a household electric product, a game playing device and a keyboard.

### Description of the Related Art

For example, Patent Document 1 discloses a power detection device in which a capacitative element including four electrodes formed on a substrate and an elastically deformable member of a rubber film disposed on this substrate is used (see the abstract).
Moreover, in the power detection device using the capacitative element according to Patent Document 1, a lower surface of the elastically deformable member is coated with a conductive coating to form a displacement conductive layer (see the abstract). The electrodes and the displacement conductive layers facing the electrodes constitute four sets of capacitative elements (see the abstract). Furthermore, an electrostatic capacity value is converted into a voltage value by a C/V conversion circuit, and an external force applied to the elastically deformable member is detected by calculation performed by a signal processing circuit (see the abstract). It is to be noted that an operation board is disposed on the elastically deformable member (see Paragraph [0030] of the specification).

Moreover, Patent Document 2 discloses a multidirectional input device in which a pressing portion of an upper surface of an operation knob is present inwardly from a diameter of a circular ring-like protruding portion of a lower surface of the knob. Moreover, a push button concentrically engages with a through hole at the center of the operation knob. When the pressing portion of the upper surface of the above operation knob is pushed to incline the portion in a desired angular direction, the push button also moves downwards. First, the operation knob pushes a flexible insulating substrate to recognize the inclined angular direction. Subsequently, when the push button pushes a circularly domed movable contact, a switch contact portion comes into contact to emit a signal while involving an indexing sensation (see Claim 6 and FIGS. 19 to 21).

[Patent Document 1] Japanese Patent Application Laid-Open No. 2003-131786; and
[Patent Document 2] Japanese Patent Application Laid-Open No. 2002-117751.

However, in the power detection device described in Patent Document 1, when the external force is applied to the elastically deformable member in a predetermined direction, the elastically deformable member is deformed. Therefore, a domed structure cannot be deformed, and the feeling of click cannot be obtained (see FIGS. 14 to 16). That is, even if a directional key is depressed in an arbitrary direction, the feeling of click cannot be obtained.

In the multidirectional input device described in Patent Document 2, after the operation knob pushes the flexible insulating substrate to recognize the inclined angular direction, the push button pushes the circularly domed movable contact. In consequence, the switch contact portion comes into contact to emit the signal while involving the indexing sensation. Therefore, while the directional key (the operation knob) is depressed in the arbitrary direction (the angular direction), the above tilted (inclined) arbitrary direction (angular direction) cannot be judged before the feeling of click is generated (before the indexing sensation is generated).

The feeling of click generated by depressing the directional key in the arbitrary direction can be recognized by an operator who has depressed the directional key in the arbitrary direction. This feeling of click usually allows the operator to recognize that the multidirectional input device detects that the directional key has been depressed in the arbitrary direction. Therefore, in the cellular phone using the conventional multidirectional input device and the like, processing has been performed in response to the depression of the directional key in the arbitrary direction after the generation of the feeling of click. This also applies to the multidirectional input device described in Patent Document 2, and this is also apparent because the switch contact portion comes into contact to emit the signal while involving the indexing sensation. Therefore, in the cellular phone using the multidirectional input device described in Patent Document 2 and the like, the detection of, before the generation of the feeling of click, the arbitrary direction of the depressed directional key before the generation of the feeling of click is not taken into consideration.

In addition, in a case where the arbitrary direction of the depression before the generation of the feeling of click is detected in the cellular phone and the like, processing (e.g., movement of a pointer at a usual speed (basically a constant speed)) can be performed in response to the directional key depressed with a predetermined small force (a force smaller than that required for depressing the directional key in the arbitrary direction to generate the feeling of click) in the arbitrary direction. On the other hand, the operator can depress the directional key in the arbitrary direction based on the feeling of click with the above small force in order to allow the cellular phone and the like to perform this processing. That is, the operator can perform an operation of adjusting the force for depressing the directional key in the arbitrary direction to move, for example, the pointer at the usual speed (basically the constant speed).

### SUMMARY OF THE INVENTION

The present invention has been developed in view of the above problem, and an object thereof is to provide a multidirectional input device capable of detecting an arbitrary direction of depression before the generation of the feeling of click to depress a directional key in the arbitrary direction with a predetermined small force (a force smaller than that required for depressing the directional key in the arbitrary direction to generate the feeling of click) based on the feeling of click.

To solve the above problem, a multidirectional input device according to the present invention is a multidirectional input device comprising: a key sheet having a center key and a directional key which surrounds this center key; a presser member disposed at a position corresponding to the center key on a back surface of the key sheet; and a click feeling generating section which is disposed so as to face the presser member and which is deformed by the presser member to generate the feeling of click, the multidirectional input device being formed into a structure in which the directional key tilts together with the center key with the depression of the directional key in an arbitrary direction, and in which the click feeling generating section is deformed by the presser member to generate the feeling of click, as the directional key is depressed in the arbitrary direction, the device further comprising: a movable element and a fixed element configured so that a distance between the movable element and the fixed element changes with the depression of the directional key in the arbitrary direction at least before the generation of the feeling of click and so that the arbitrary direction of the depression is detected from the change of the distance at least before the generation of the feeling of click.

In a case where this multidirectional input device is used in a predetermined electronic device, the arbitrary direction of the depression before the generation of the feeling of click can be detected by the movable element and the fixed element. According to the structure in which the directional key tilts together with the center key with the depression of the directional key in the arbitrary direction, the presser member can move in a predetermined case. Moreover, according to the structure in which the click feeling generating section is deformed by the presser member to generate the feeling of click in a case where the directional key is depressed in the arbitrary direction, when the directional key is depressed in the arbitrary direction, the feeling of click is obtained. Therefore, an operator can depress the directional key in the arbitrary direction with a predetermined small force (i.e., a force smaller than that required for depressing the directional key in the arbitrary direction to generate the feeling of click) based on the feeling of click.

Moreover, in the multidirectional input device according to the present invention, the movable element and the fixed element are configured so that the distance between the movable element and the fixed element changes with the depression of the directional key in the arbitrary direction before the generation of the feeling of click and so that the arbitrary direction of the depression is detected from this change of the distance before and after the generation of the feeling of click.

In a case where this multidirectional input device is used in the predetermined electronic device, the arbitrary direction of the depression before the generation of the feeling of click can be detected by the movable element and the fixed element. Furthermore, when the directional key is depressed in the same direction, the key cannot be depressed in the same direction any more after the generation of the feeling of click in some case. Even in this case, if this operation is not cancelled, it is possible to detect, even after the generation of the feeling of click, the same direction of the depression before the generation of the feeling of click from the change of the distance between the movable element and the fixed element before the generation of the feeling of click. In consequence, before and after the generation of the feeling of click, the processing corresponding to the direction (the same direction) detected before the generation of the feeling of click can be performed. For example, to move the pointer in a screen, in a case where the directional key is depressed in the same direction (e.g., the right direction), the directional key cannot be depressed in the same direction any more after the generation of the feeling of click. Even in this case, if this operation is not cancelled, it is possible to perform processing to move the pointer at a usual speed (basically a constant speed) before the generation of the feeling of click and accelerate and move the pointer after the generation of the feeling of click.

Moreover, in the multidirectional input device according to the present invention, the movable element and the fixed element are configured so that the distance between the movable element and the fixed element changes with the depression of the directional key in the arbitrary direction before and after the generation of the feeling of click and so that the arbitrary direction of the depression is detected from this change of the distance before and after the generation of the feeling of click.

In consequence, in a case where this multidirectional input device is used in the predetermined electronic device, the arbitrary direction of the depressions before and after the generation of the feeling of click can be detected by the movable element and the fixed element. Therefore, while the directional key is depressed in the arbitrary direction, the feeling of click is generated, and the arbitrary direction of the depression before and after the generation of the feeling of click can be detected. Consequently, it is possible to perform the processing corresponding to the detection of the arbitrary direction of the depression before and after the generation of the feeling of click. For example, in a case where the pointer is moved in the screen, it is possible to perform the processing to move the pointer at the usual speed (basically the constant speed) before the generation of the feeling of click and accelerate and move the pointer after the generation of the feeling of click.

It is to be noted that in the present invention, the "depressing" in the arbitrary direction is specifically to depress the directional key in one arbitrary direction (a unidirectional operation of the directional key). Additionally or alternatively, the "depressing" is sometimes to depress the directional key along a predetermined distance of the surface of the directional key in a circumferential direction with substantially the same force (a rotating operation of the directional key). This rotating operation of the directional key is used in, for example, changing a movement direction of the pointer, selecting an item, selecting items vertically arranged in one row in order and the like. It is to be noted that processing may be performed to accept the only unidirectional operation of the directional key (or the rotating operation of the directional key) before the generation of the feeling of click and accept the only rotating operation of the directional key (or the unidirectional operation of the directional key) before the generation of the feeling of click.

Moreover, in the multidirectional input device according to the present invention, the movable element and the fixed element are further configured to measure a strength and/or a speed of a force used in the depression of the arbitrary direction from the change of the distance.

In a case where this multidirectional input device is used in the predetermined electronic device, from the change of the distance of movable element and the fixed element, the strength (i.e., a position to which the directional key has been depressed in the arbitrary direction) and/or the speed (i.e., the speed at which the directional key has been depressed in the arbitrary direction) of the force used in depressing the directional key in the arbitrary direction can be measured, it is possible to perform processing corresponding to the strength and/or the speed of the force.

Moreover, in the multidirectional input device according to the present invention, the key sheet further has a sheet-like member on which the center key and the directional key are arranged.

Furthermore, in the multidirectional input device according to the present invention, the movable element is disposed on a backside of the key sheet so as to move with the tilting of the center key and the directional key, and the fixed element is disposed so as to face the movable element.

In consequence, it is possible to set a movement distance of a movable electrode to a distance required for the detection of the direction.

Moreover, the multidirectional input device according to the present invention further comprises a tilt direction changing member which changes a tilt direction of the center key and the directional key so that the directional key moves downwards in a direction reverse to the arbitrary direction, as the directional key is depressed in the arbitrary direction, and the click feeling generating section is deformed by the presser member to generate the feeling of click, as the directional key is further depressed in the arbitrary direction after the change of the tilt direction of the center key and the directional key.

Furthermore, in the multidirectional input device according to the present invention, the tilt direction changing member is disposed so that the force required for depressing the directional key in the arbitrary direction to tilt the center key and the directional key is larger after the change of the tilt direction than before the change of the tilt direction.

The force required for depressing the directional key in the arbitrary direction to tilt the center key and the directional key is larger after the change of the tilt direction than before the change of the tilt direction. In consequence, when the directional key is depressed in the arbitrary direction, the force required for depressing the directional key in the arbitrary direction to generate the feeling of click becomes larger than usual. Therefore, while the force is gradually applied, a generation point of the feeling of click can be displaced. In consequence, a range of the predetermined small force (i.e., the force smaller than that required for depressing the directional key in the arbitrary direction to generate the feeling of click) during the depression of the directional key in the arbitrary direction can be broadened. Therefore, the operator can easily depress the directional key in the arbitrary direction before the generation of the feeling of click.

Moreover, in the multidirectional input device according to the present invention, at least one of the tilt direction changing member and the presser member can be deformed, and the tilt direction changing member and/or the presser member is deformed to further tilt the center key and the directional key, as the directional key is further depressed in the arbitrary direction after the generation of the feeling of click.

In consequence, after the generation of the feeling of click, the center key and the directional key can tilt.

Furthermore, in the multidirectional input device according to the present invention, the movable element has a slope with respect to the fixed element.

In consequence, as compared with the movable element is disposed in parallel with the fixed element, the distance between the movable element and the fixed element can be reduced.

Moreover, in the multidirectional input device according to the present invention, the movable element is a movable electrode, the fixed element is a fixed electrode, and the distance between the movable element and the fixed element is an electrostatic capacity.

In consequence, the device may be used in detecting the arbitrary direction of the depression from a change of the electrostatic capacity.

In addition, the multidirectional input device according to the present invention further comprises a space disposed above the movable electrode, and an insulating layer disposed on the surface of at least one of the movable electrode and the fixed electrode. The device is configured so that, as the directional key is depressed in the arbitrary direction, with the tilting of the center key and the directional key, the movable electrode moves to come into contact with the fixed electrode via the insulating layer and so that, as the movable electrode comes into contact with the fixed electrode, the space gradually collapses.

With the tilting of the center key and the directional key, the movable electrode moves to come into contact with the fixed electrode via the insulating layer. Therefore, the distance between the movable electrode and the fixed electrode can be reduced. Furthermore, since the space disposed above the movable electrode gradually collapses, the movable electrode smoothly comes into contact with the fixed electrode via the insulating layer.

Moreover, the multidirectional input device according to the present invention further comprises a space disposed above the movable electrode, two contacts for short-circuit arranged on an inner side or an outer side of the fixed electrode, and an insulating layer disposed on at least one of the surface of a portion of the movable electrode which does not come into contact with the two contacts for short-circuit and the surface of the fixed electrode. The device is configured so that, as the directional key is depressed in the arbitrary direction, with the tilting of the center key and the directional key, the movable electrode moves to first short-circuit the contact for short-circuit and come into contact with the fixed electrode via the insulating layer and so that, as the movable electrode comes into contact with the fixed electrode, the space gradually collapses.

Since the movable electrode comes into contact with the fixed electrode via the insulating layer, the distance between the movable electrode and the fixed electrode can be reduced. Furthermore, since the space disposed above the movable electrode gradually collapses, the movable electrode smoothly comes into contact with the fixed electrode via the insulating layer. Moreover, the contact for short-circuit can be short-circuited to thereby start the detection of the direction.

Furthermore, in the multidirectional input device according to the present invention, a bent portion which is developed with the downward movement of the center key is further disposed in the sheet-like member at outer peripheral portions of the center key.

According to this bent portion, the center key can smoothly move downwards.

Moreover, in the multidirectional input device according to the present invention, a bent portion which is developed with the tilting of the directional key is further disposed in the sheet-like member at outer peripheral portions of the directional key.

According to this bent portion, the directional key can smoothly tilt.

In the present invention, the "center key" and the "directional key" are basically arranged independently of each other. The keys may be secured integrally or with an adhesive, a binder or the like to form one key. It is assumed that, when the keys are integrally formed as one key, the center is the "center key", and a surrounding portion around this center is the "directional key". However, in a case where the "bent portion which is developed with the downward movement of the center key" is disposed, the "center key" needs to be disposed separately from the "directional key".

In the present invention, the "key sheet" may have at least the center key and the directional key. In the present invention, even a key sheet formed of the center key and the directional key only is referred to as the "key sheet".

In the present invention, the expression "a distance between the movable element and the fixed element changes with the depression of the directional key in the arbitrary direction at least before the generation of the feeling of click and so that the arbitrary direction of the depression is detected from the change of the distance at least before the generation of the feeling of click" or the like does not mean that the detection of the arbitrary direction has to be necessarily started immediately after the movement of the movable element (e.g., immediately after the directional key is depressed in the arbitrary direction). Specifically, the detection of the arbitrary direction may be started before the generation of the feeling of click. Examples of a start point of the detection of the arbitrary direction may include not only a point immediately after the directional key is depressed in the arbitrary direction (e.g., the directional key is lightly toughed) but also a point before the movable element moves to a predetermined position to change the tilt direction of the center key and the directional key, a point after the tilt direction of the center key and the directional key changes and the like.

In the present invention, the movable element disposed on the "backside" of the key sheet is basically directly disposed on the back surface of the key sheet, but may appropriately be buried in the key sheet as long as the direction can be detected in accordance with the change of the distance between the movable element and the fixed element.

In the present invention, the "sheet-like member on which the center key and the directional key are arranged" conceptually includes the "sheet-like member" integrally provided with the "center key" and/or the "directional key".

Moreover, in the present invention, the "sheet-like member" is basically one sheet-like member, but a plurality of members may be formed as one sheet. Even in a case where at least a part of the plurality of members is physically disposed separately, if at least a part of the members is provided with the center key and the directional key, the members are entirely referred to as the "sheet-like member". Furthermore, the "sheet-like member" may have concave and convex portions.

According to the present invention, there can be provided a multidirectional input device capable of detecting the arbitrary direction of the depression before the generation of the feeling of click to depress the directional key in the arbitrary direction with the predetermined small force (the force smaller than that required for depressing the directional key in the arbitrary direction to generate the feeling of click) based on the feeling of click.

### BRIEF DESCRIPTION OF THE DRAWINGS

FIG. 1 is a schematic explanatory view of a cellular phone using a multidirectional input device according to one example of a first embodiment of the present invention;
FIG. 2 is a plan view of a cellular phone using a multidirectional input device according to one example of the first embodiment of the present invention;
FIG. 3(a) is a sectional view of the multidirectional input device according to one example of the first embodiment of the present invention, and (b) is a plan view of the multidirectional input device according to one example of the first embodiment of the present invention;
FIG. 4 is a schematic diagram of a back surface of a key sheet for use in the multidirectional input device according to one example of the first embodiment of the present invention;
FIG. 5 is a schematic diagram of a substrate for use in the multidirectional input device according to one example of the first embodiment of the present invention;

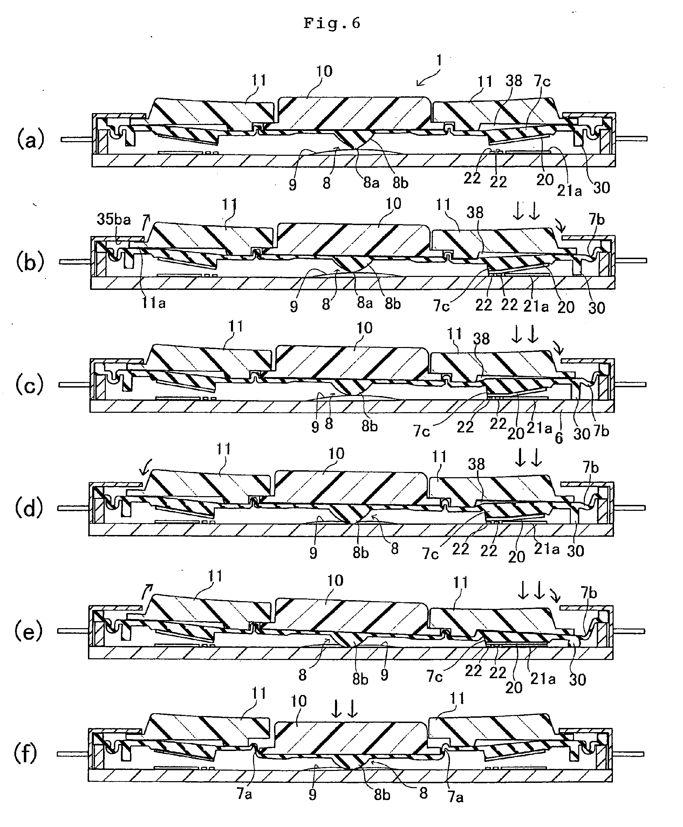

FIG. 6(a) is a sectional view showing an initial state of the multidirectional input device according to one example of the first embodiment of the present invention, (b) to (e) are sectional views showing states of the multidirectional input device according to one example of the first embodiment of the present invention in order in a case where a directional key is depressed in an arbitrary direction (here, the rightward direction), and (f) is a sectional view showing a state of the multidirectional input device according to one example of the first embodiment of the present invention in a case where a center key is depressed;
FIG. 7 is a sectional view of a multidirectional input device according to one example of a second embodiment;
FIG. 8 is a sectional view of a multidirectional input device according to one example of a third embodiment;
FIG. 9(a) is a sectional view of a multidirectional input device according to one example of a fourth embodiment, and (b) is a schematic sectional view showing a state of the multidirectional input device according to one example of the fourth embodiment in a case where a directional key is depressed and operated in an arbitrary direction;
FIG. 10 is a sectional view of a multidirectional input device according to one example of a fifth embodiment; and
FIG. 11 is a perspective view of a key sheet having a center key, a directional key and a sheet-like member on which these keys are arranged for use in a multidirectional input device according to one example of an embodiment of the present invention.

### DESCRIPTION OF THE REFERENCE NUMERALS

- 1: multidirectional input device
- 2: key sheet
- 3: general keys
- 6: substrate
- 7: sheet-like member
- 7 a: first bent portion
- 7 b: second bent portion
- 7 c: seat
- 8, 8 0: presser member
- 8 a: small protrusion
- 9: click feeling generating section
- 1 0: center key
- 1 1: directional key
- 2 0: movable electrode
- 2 1: fixed electrode
- 2 2: linear ring electrodes
- 3 0: tilt direction changing member
- 3 8 , 8 1 , 8 4: space

### DESCRIPTION OF THE PREFERRED EMBODIMENTS

A multidirectional input device according to one example of an embodiment of the present invention will hereinafter be described with reference to the drawings. It is to be noted that in the drawing, similar components, corresponding components and generic components are denoted with the same reference numerals for description. In the drawings, an only part of a plurality of similar components, corresponding components and generic components are denoted with reference numerals in some case.

### (First Embodiment)

In the present invention, a case where a multidirectional input device according to one example of a first embodiment of the present invention is used in a cellular phone will be described.

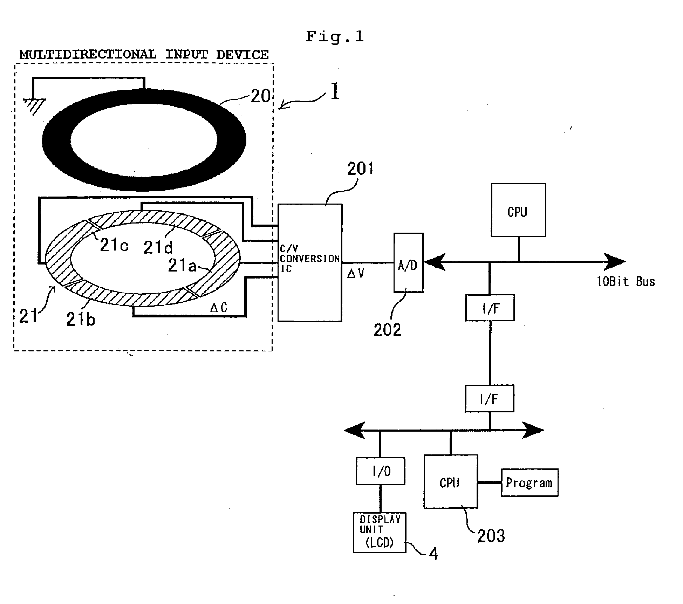

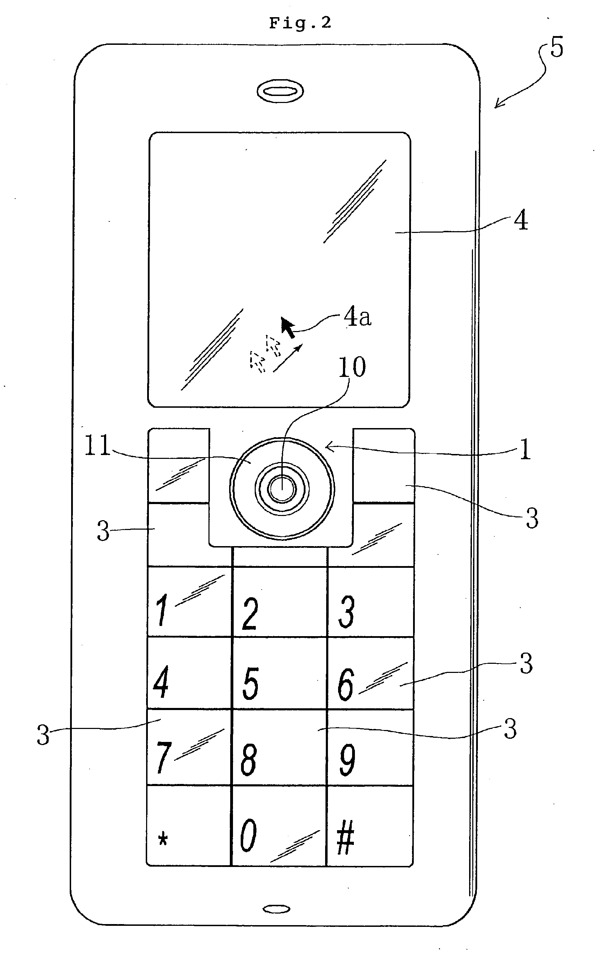

FIG. 1 is a schematic explanatory view of the cellular phone in which a multidirectional input device 1 is used according to one example of a first embodiment of the present invention. FIG. 2 is a plan view of the cellular phone in which a multidirectional input device 1 is used according to one example of the first embodiment of the present invention. It is to be noted that in FIG. 1, fixed electrodes 21a, 21b, 21c and 21d are hatched to clarify the fixed electrodes 21a, 21b, 21c and 21d, and the hatching does not show a section.

As described later in detail, the multidirectional input device 1 includes a movable electrode 20, a fixed electrode 21, and a directional key 11 (not shown in FIG. 1).

The fixed electrode 21 is divided into four electrodes (the number of the divided electrodes may appropriately be changed as described later). The fixed electrodes 21a, 21b, 21c and 21d are these divided electrodes. The movable electrode 20 moves with an operation of depressing the directional key 11 in an arbitrary direction.

The movable electrode 20 and the fixed electrodes 21a, 21b, 21c and 21d constitute four capacitative elements in vertical and horizontal directions. With the operation of depressing the directional key 11 in the arbitrary direction, the movable electrode 20 moves. Therefore, a distance between the movable electrode 20 and the fixed electrode 21, that is, a mutual distance (a positional relation) between the movable electrode 20 and the fixed electrode 21 changes. Owing to the change of this distance (the positional relation), electrostatic capacities of such four capacitative elements change. That is, the arbitrary direction of the depressed directional key 11 can be detected from the change of the electrostatic capacity with the movement of the movable electrode 20. It is to be noted that the electrostatic capacities may appropriately be combined.

A C/V conversion IC 201, an A/D 202, a CPU 203 and the like constitute a control unit. The A/D 202, the CPU 203 and the like constituting the control unit may appropriately be modified to a logical circuit such as a signal processing circuit.

The control unit performs processing to detect the arbitrary direction of the depression of the directional key 11 from the change of the electrostatic capacity with the depression of the directional key in the arbitrary direction. The control unit may perform processing to detect, before and after the generation of feeling of click, the arbitrary direction of the depression of the directional key 11 from the change of the electrostatic capacity with the depression of the directional key in the arbitrary direction before the generation of the feeling of click.

Moreover, the control unit may further perform processing to measure a strength and/or a speed of a force used in depressing the directional key 11 in the arbitrary direction, from the change of the electrostatic capacity.

A change amount of the electrostatic capacity due to the changes of the electrostatic capacities of the four capacitative elements is converted into a change amount (ΔV) of a voltage value by the C/V conversion IC 201. The change amount of the voltage value is converted into a digital signal by the A/D 202. The CPU 203 recognizes the change amounts of the four electrostatic capacities from the converted digital signal. The arbitrary direction of the depressed directional key 11 is detected from the recognized change amounts of the four electrostatic capacities. When the change amounts of the electrostatic capacities (here, especially a balance of the changes of the electrostatic capacities of each capacitative elements) are used in the detection of the direction, it is theoretically possible to detect all the arbitrary directions of 360 degrees. Moreover, in response to the detected arbitrary direction, the CPU 203 performs processing such as the moving of a pointer 4a of a screen described later in accordance with this arbitrary direction.

Furthermore, the strength and/or the speed of the force used in depressing the directional key 11 in the arbitrary direction can further be measured from the change amount of the electrostatic capacity. The strength of the force is seen from the change amount of the electrostatic capacity. The speed of the force may be obtained by dividing the change amount by time required for depressing the key. The control unit may perform the processing in accordance with the strength and/or the speed of this force. Assuming that both of them are measured to perform the processing in accordance with them, for example, in a case where the pointer 4a of the screen is moved by the directional key 11, a movement amount of the pointer 4a is determined in accordance with a degree of the depressing (the strength of the force) of the directional key 11 in the arbitrary direction to move the pointer. A movement speed of the pointer 4a is determined in accordance with a speed (the speed of the force) at which the directional key 11 has been depressed in the arbitrary direction to move the pointer. In consequence, the processing in moving the pointer 4a and the like can be performed in accordance with three elements including the movement direction, the movement amount and the movement speed. Therefore, the processing can be reflected in depressing the directional key 11 in the arbitrary direction (the movement of the pointer 4a can be reflected in depressing the key), and an operability is improved. Only after the generation (or before the generation) of the feeling of click, the processing may be performed in accordance with the strength and/or the speed of this force. For example, before the generation (or after the generation) of the feeling of click, the pointer 4a moves at a usual speed (basically a constant speed). After the generation (or before the generation), the movement amount and/or the movement speed of the pointer 4a may be changed in accordance with the strength and/or the speed of the force. In consequence, an operator can recognize that the processing during the movement of the pointer 4a changes based on the feeling of click. During the processing in accordance with the strength of the force, for example, to move the pointer 4a of the screen by the directional key 11, the movement speed of the pointer 4a may be changed in accordance with (in proportion to) the degree of the depressing (the strength of the force) of the directional key 11 in the arbitrary direction. In consequence, the operability improves. For example, only after the generation (or before the generation) of the feeling of click, the movement speed of the pointer 4a may be changed (accelerated or decelerated) in accordance with the strength of the force. The strength of the force or the like may be processed to appropriately add an element (e.g., acceleration during the movement of the pointer 4a, etc.) other than the movement direction, the movement amount and the movement speed.

It is to be noted that the arbitrary direction may be detected from the value of the electrostatic capacity instead of the change amount of the electrostatic capacity. For example in a case where the directional key corresponding to the fixed electrode 21a is depressed in a certain range of direction (or a certain range of direction centering on a space between the fixed electrode 21a and the fixed electrode 21d) in accordance with the change of the electrostatic capacity, it may be detected that the key has been depressed in the right direction corresponding to the fixed electrode 21a (or an upper right direction corresponding to the center between the fixed electrode 21a and the fixed electrode 21d).

Moreover, the strength and/or the speed of the force used in depressing the directional key 11 in the arbitrary direction may be measured in accordance with the value of the electrostatic capacity instead of the change amount of the electrostatic capacity.

The detection of the arbitrary direction of the depressed directional key 11 or the measurement of the strength and/or the speed of the force used in depressing the directional key 11 in the arbitrary direction is performed by an appropriate method in accordance with the change of the electrostatic capacity (the change amount of the electrostatic capacity or the value of the electrostatic capacity). The processing of the detected arbitrary direction, the measured strength of the force and the measured speed of the force to display them on the screen (e.g., the moving of the pointer 4a or the like) is appropriately determined. The other factors described above are appropriately determined.

A cellular phone 5 has a display unit 4, general keys 3 (keys such as ten keys and functional keys, this also applies to the following), a center key 10 and the directional key 11 which surrounds the center key 10. A predetermined screen is displayed in the display unit 4. Screen display of the display unit 4 switches in response to input from the general keys 3, the center key 10 or the directional key 11.

The directional key 11 is used in selecting an icon (selecting one of a plurality of icons displayed in the screen) displayed in the screen (sometimes referred to simply as the screen in the present invention) of the display unit 4, selecting an item from a menu (selecting one item from the menu displayed in the screen), moving a character, moving the pointer 4a and the like.

For example, in a case where the pointer 4a of the screen is moved by operating the directional key 11, when the directional key 11 is depressed in the arbitrary direction (the upper right direction in FIG. 2), the pointer 4a smoothly moves from a position shown by a broken line to a position shown by a solid line (see arrows in FIG. 2) in a direction (the upper right direction in FIG. 2) corresponding to this arbitrary direction.

During use of the center key 10, the key is depressed to thereby determine the selected icon, the selected item and the like. The center key 10 is depressed to thereby perform an operation corresponding to clicking for moving the pointer 4a. It is to be noted that, even if the key surrounded with the directional key 11 is not used in this manner, the key is referred to as the center key 10 in the present invention.

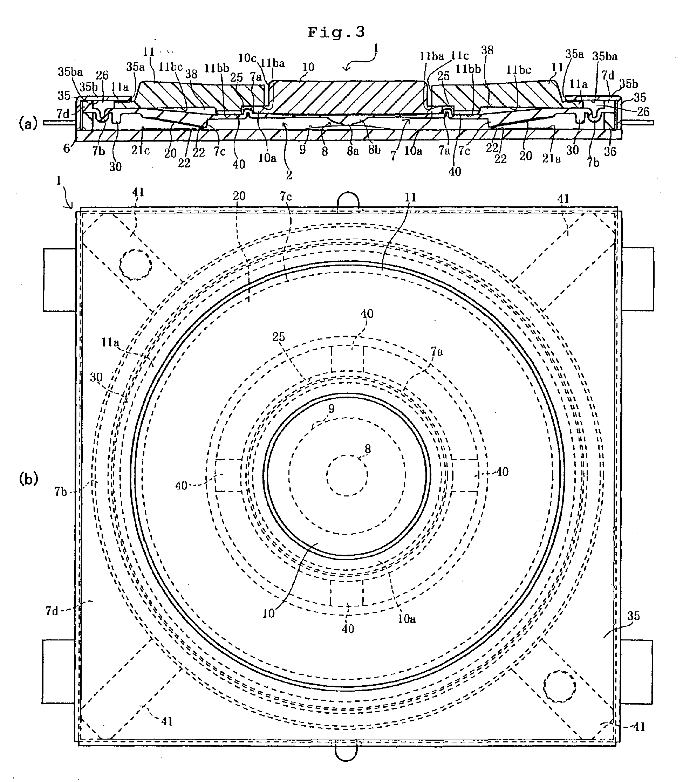

FIG. 3(a) is a sectional view of the multidirectional input device 1 according to one example of the first embodiment of the present invention. FIG. 3(b) is a plan view of the multidirectional input device 1 according to one example of the first embodiment of the present invention. It is to be noted that in FIG. 3(a), hatching is omitted from sections of the movable electrode 20, the fixed electrodes 21a, 21c and two linear ring electrodes 22, and they are shown in black.

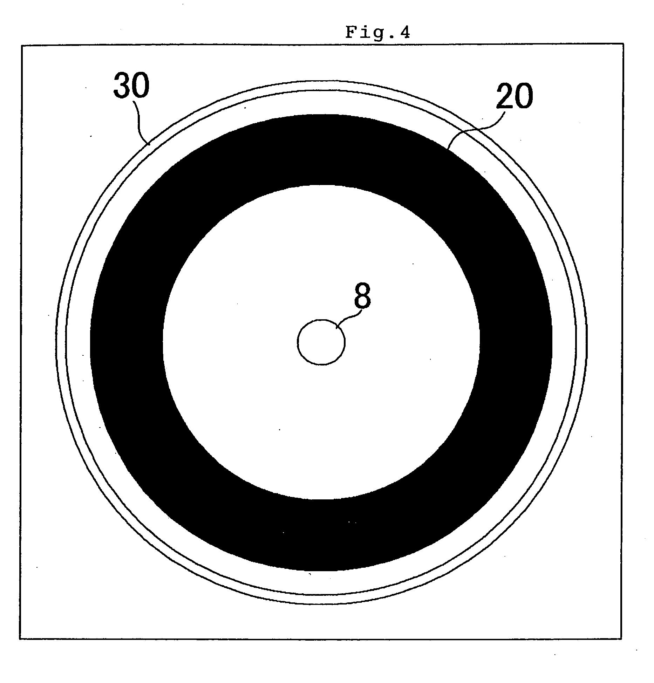

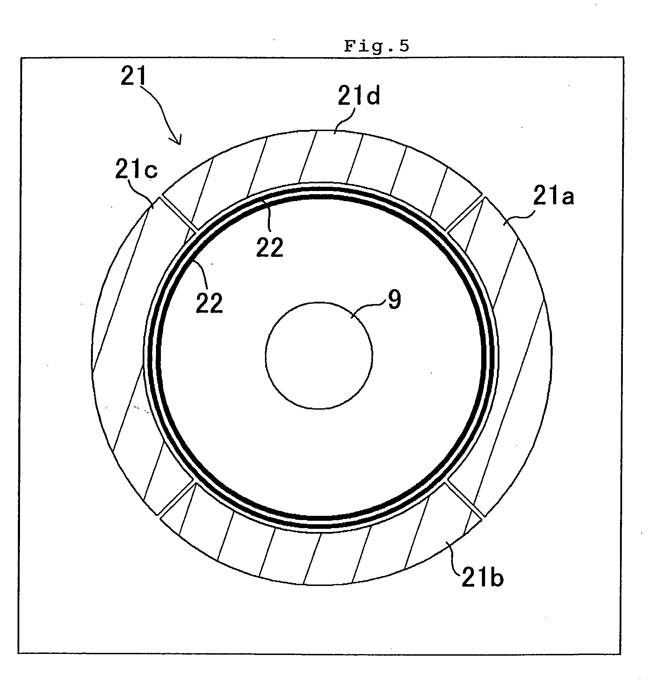

FIG. 4 is a schematic diagram of a back surface of a key sheet 2 for use in the multidirectional input device 1 according to one example of the first embodiment of the present invention. It is to be noted that, in FIG. 4, a first bent portion 7a, a second bent portion 7b and the like are omitted, and the movable electrode is shown in black. FIG. 5 is a schematic diagram of a substrate 6 for use in the multidirectional input device 1 according to one example of the first embodiment of the present invention. In FIG. 5, the linear ring electrode 22 is shown in black, a predetermined wiring pattern and the like (see FIG. 1) are omitted, and the fixed electrodes 21a, 21b, 21c and 21d are hatched (here, the hatching does not show any section).

The multidirectional input device 1 includes the key sheet 2, a presser member 8, a click feeling generating section 9, the movable electrode 20, the fixed electrode 21 and the two linear ring electrodes 22. The key sheet 2 has the center key 10, the directional key 11 and a sheet-like member 7. As described later, the multidirectional input device 1 is formed into a structure in which the directional key 11 tilts together with the center key 10 with the depression of the directional key 11 in the arbitrary direction, and in which the click feeling generating section 9 is deformed by the presser member 8 to generate the feeling of click as the directional key 11 is depressed in the arbitrary direction.

Furthermore, the multidirectional input device 1 includes the substrate 6, a cover member 35 disposed on this substrate 6 and a support member 36 which supports the key sheet 2 on the substrate 6. A required wiring line pattern (not shown) is made of copper or the like on the substrate 6. As shown in FIG. 1, necessary elements and the like (not shown) are arranged on the substrate 6. The cover member 35 has a through hole 35a in an upper surface of the member.

The key sheet 2 is supported by the support member 36 so that the upper surface (a portion to be depressed) of the center key 10 and the upper surface (a portion to be depressed) of the directional key 11 are exposed from the through hole 35a. In consequence, the key sheet 2 is supported so that the back surface of the key sheet faces the substrate 6.

The directional key 11 is shaped so as to surround the center key 10, and has an annular shape here. The center key 10 has a circular shape here, but the shape may appropriately be changed. The directional key 11 may have a shape such as a polygonal shape having a through hole at which the center key 10 can be disposed. There is not any restriction on the shape of the directional key 11 as long as the center key 10 can be surrounded.

The center key 10 includes a flange 10a which protrudes in a horizontal direction from a lower peripheral edge of a main body of this center key 10. The flange 10a is formed integrally with the center key 10 and formed of the same material as that of the center key, but the flange may be formed separately from the main body of the center key 10 and bonded using an adhesive or a binder.

The directional key 11 includes a flange 11a which protrudes in a horizontal direction from a lower peripheral edge of a main body of this directional key 11. The flange 11a is formed integrally with the directional key 11 and formed of the same material as that of the directional key, but the flange may be formed separately from the main body of the directional key 11 and bonded using the adhesive or the binder.

The center key 10 and the directional key 11 may appropriately be made of any synthetic resin including a hard resin such as a polycarbonate resin, a polyurethane-based resin or a silicone-based resin, any glass, a metal or the like.

A stepped surface 11ba, a stepped surface 11bb and a stepped surface 11bc are disposed on the back surface of the directional key 11. The flange 10a of the center key 10 is disposed under the stepped surface 11ba so as to dispose a first gap 25 described later, and abuts on this stepped surface 11ba. That is, the center key 10 engages with the directional key 11 so that the keys tilt together. In consequence, floating of the center key 10, that is, jumping of the center key 10 from this multidirectional input device 1 can be prevented.

The flange 11a of the directional key 11 is disposed under an upper portion 35b of the cover member 35. In consequence, floating of the directional key 11, that is, jumping of the directional key 11 from this multidirectional input device 1 can be prevented.

It is to be noted that a lower surface 35ba of the upper portion 35b of the cover member 35 may abut on the flange 11a (the lower surface may abut on the flange from the beginning). When the directional key is depressed in the arbitrary direction, an end portion of the flange 11a on a side opposite to the depressed direction abuts on the lower surface 35ba, and this abutment portion is a tilt support of the center key 10 and the directional key 11.

The center key 10 and the directional key 11 are arranged at predetermined positions on the surface of the sheet-like member 7. For example, the center key 10 and the directional key 11 are secured to desires portions (the whole back surface of the center key, the flange 11a and the stepped surface 11bb of the directional key 11) at the predetermined positions on the surface of the sheet-like member 7 by use of the adhesive, the binder or the like.

The sheet-like member 7 is formed as a sheet by use of a rubber material such as a silicone rubber, a thermoplastic elastomer, any synthetic resin or the like. In a case where the sheet-like member 7 has a portion in which the general keys 3 including the ten keys, the functional keys and the like are arranged, that is, a case where the sheet-like member 7 is formed as a so-called key base of the key sheet having a part of the multidirectional input device 1 and the general keys 3, especially in order to impart rigidity to the portion where the general keys 3 are to be arranged and impart shape stability to the whole sheet-like member 7, the sheet-like member 7 is sometimes formed integrally with a so-called reinforcing plate (a frame member) made of a metal or any synthetic resin including a hard resin such as a polycarbonate resin, a polyurethane-based resin or a silicone-based resin by thermal fusion bonding, adhesion or the like. In the present embodiment, the sheet-like member 7 is formed as one sheet of an elastic material such as a rubber material like a silicone rubber or a thermoplastic elastomer.

It is to be noted that the sheet-like member 7 is basically a member in the form of one sheet, but a plurality of members may be formed into one sheet. The sheet-like member may be separated into a plurality of members. For example, the sheet-like member 7 may be cut from the center of the stepped surface 11bb.

At least a part of the sheet-like member 7 may be deformable by having elasticity or the like (It is to be noted that it is preferable that there is a restoring force as in the member having elasticity).

However, for example, the second bent portion 7b described later or a position corresponding to this second bent portion in a case where the second bent portion 7b is not disposed needs to be deformable so that both of the center key 10 and the directional key 11 can tilt. That is, at least a part of the sheet-like member 7 needs to be deformable so that both of the center key 10 and the directional key 11 are tiltable in a case where the directional key 11 is depressed in the arbitrary direction.

Moreover, in a case where the center key 10 and the directional key 11 are separately arranged, for example, the first bent portion 7a described later or a position corresponding to the first bent portion 7a in a case where this first bent portion 7a is not disposed needs to be deformable so that the center key 10 is moved downwards by depressing the center key 10. That is, a part of the sheet-like member 7 additionally needs to be deformable so that the center key 10 is moved downwards by depressing the center key 10.

The sheet-like member 7 includes the first bent portion 7a, the second bent portion 7b, a seat 7c and an end portion 7d. The movable electrode 20 described later is disposed on the seat 7c. The end portion 7d is fixed to or abuts on the support member 36 to support the sheet-like member 7, that is, the key sheet 2 on the substrate 6.

The first bent portion 7a is formed by bending a predetermined portion of the sheet-like member 7 into an inverted substantially sectional U-shape. This first bent portion 7a is contained in the first gap 25. The first gap 25 is disposed outside the end portion of the flange 10a and under the stepped surface 11ba.

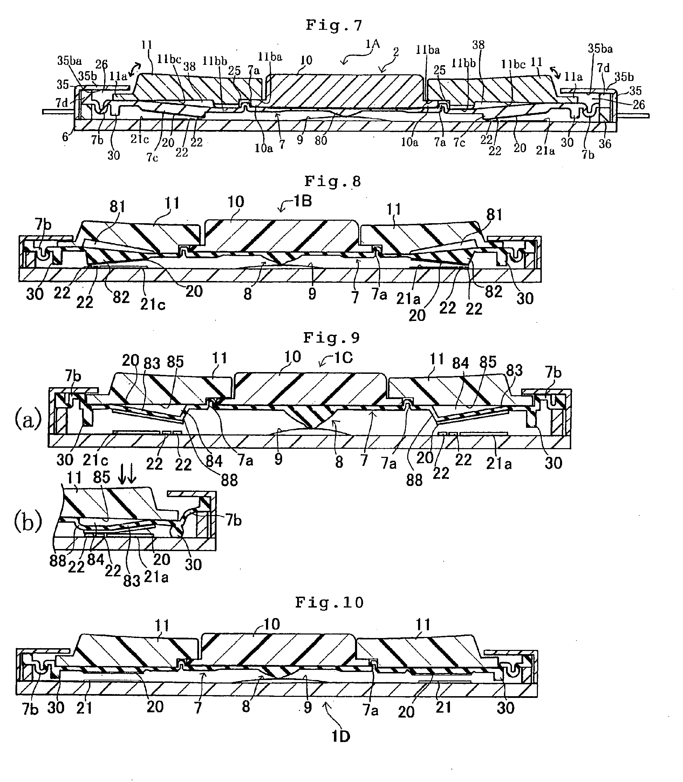

A shape of the first bent portion 7a may appropriately be changed. The first bent portion 7a may be formed by, for example, bending the sheet-like member 7 into a substantially sectional U-shape in a direction opposite to that of the first bent portion 7a shown in FIG. 3(a) and the like, that is, in a downward direction. In this case, the first gap 25 is not especially required. The first bent portion 7a may be formed into a substantially sectional "⊐"-shape as shown in FIG. 9.

The first bent portion 7a is developed with the downward movement of the center key 10 in a case where the center key 10 is depressed. In consequence, the deformation of the sheet-like member 7 and the downward movement of the center key 10 are smoothly performed.

The second bent portion 7b is formed into a substantially bellows-like shape by bending a predetermined portion of this sheet-like member 7 into a substantially sectional U-shape. In this case, a space which can contain the second bent portion 7b is disposed.

A shape of the second bent portion 7b may appropriately be changed. The second bent portion 7b may be formed by, for example, bending the sheet-like member into an inverted substantially sectional U-shape in a direction opposite to that of the second bent portion 7b shown in FIG. 2(a) and the like, that is, in an upward direction. In this case, a second gap 26 needs to be disposed outside an end portion of the flange 11a. The second bent portion 7b may be formed into a substantially sectional "⊐"-shape as shown in FIG. 9.

The second bent portion 7b is developed with the tilting of the directional key 11 and the center key 10. When the directional key 11 is depressed in the arbitrary direction, the second bent portion 7b is appropriately developed with the tilting of the directional key. In consequence, the deformation of the sheet-like member 7 and the tilting of the directional key 11 and the center key 10 can smoothly be performed.

The first bent portion 7a and the first gap 25 are annularly arranged along an outer peripheral portion of the center key 10. The second bent portion 7b is annularly disposed along an outer peripheral portion of the directional key 11. The second gap 26 is annularly disposed along the outer peripheral portion of the directional key 11. The first bent portion 7a, the first gap 25, the second bent portion 7b and the second gap 26 are concentrically formed, respectively.

The first bent portion 7a, the first gap 25, the second bent portion 7b and the second gap 26 may not have the annular shapes, and the shapes may appropriately be changed in accordance with the shapes of the center key 10 and the directional key 11. In a case where the center key has, for example, a substantially quadrangular shape, the first bent portion 7a and the first gap 25 are arranged in accordance with this substantially quadrangular shape.

The presser member 8 is disposed at a position corresponding to the center key 10 on the back surface of the key sheet 2 (a position under the center of the back surface of the center key 10). For example, as shown in FIG. 3(a), the presser member 8 is formed integrally with the sheet-like member 7 and formed of the same material as that of the sheet-like member. For example, the presser member 8 may be formed separately from the sheet-like member 7 beforehand, made of any synthetic resin, a metal or the like, and secured to the sheet-like member 7 by use of the adhesive or the binder. For example, a through hole may be disposed at a desired position of the sheet-like member 7 where the presser member 8 is to be disposed to directly form the presser member integrally with the center key 10 on the back surface of the center key 10. Alternatively the presser member 8 may be formed separately from the center key 10 beforehand, made of any synthetic resin, a metal or the like and then secured to the center key 10 by use of the adhesive, the binder or the like.

The presser member 8 is integrally provided with a small protrusion 8a. A tip end of the small protrusion 8a abuts on the click feeling generating section 9 described later. It is assumed that the small protrusion 8a is deformable (it is preferable that the small protrusion has elasticity). When the presser member 8 moves downwards, the small protrusion 8a is deformed and collapsed by the click feeling generating section 9. In consequence, a stroke can be secured so that the directional key 11 can tilt. Any small protrusion 8a may not be disposed in some case. In this case, a space needs to be disposed between the presser member 8 and the click feeling generating section 9 in order to secure the stroke so that the directional key 11 can tilt.

The click feeling generating section 9 is disposed so as to face the presser member 8. Specifically, the click feeling generating section 9 is disposed on the substrate 6. The click feeling generating section 9 is pressed and deformed by the presser member 8 to generate the feeling of click. The click feeling generating section 9 is realized by fixing, for example, a metal dome, a poly dome or the like to the substrate 6 via a film (not shown) (so-called a dome sheet). The film is made of polyethylene terephthalate, polycarbonate or the like. When electricity is conducted to a fixed contact (not shown) of the substrate 6, the click feeling generating section 9 can perform an operation of switching ON/OFF.

When the directional key 11 is depressed in the arbitrary direction, a tilt direction changing member 30 changes the tilt direction of the center key 10 and the directional key 11 so that portions of the keys in a direction opposite to this arbitrary direction move downwards. The tilt direction changing member 30 moves downwards with the tilting of the center key 10 and the directional key 11, and abuts on the substrate 6 to change the tilt direction of the center key 10 and the directional key 11 as described above (here, the direction is changed to a substantially reverse direction).

The tilt direction changing member 30 is formed integrally with the sheet-like member 7. The tilt direction changing member 30 may be disposed by an appropriate method such as a method in which the member is made of any synthetic resin, a metal or the like beforehand and secured to the sheet-like member 7 by use of the adhesive, the binder or the like.

The tilt direction changing member 30 may be disposed integrally with the substrate 6 on a substrate 6 side or disposed by an appropriate method such as a method in which the member is made of any synthetic resin, a metal or the like beforehand and secured to the substrate 6 by use of the adhesive, the binder or the like. In this case, the tilt direction changing member 30 abuts on the sheet-like member 7 which moves downwards to change the tilt direction of the center key 10 and the directional key 11 as described above (here, the direction is changed to the substantially reverse direction).

The tilt direction changing member 30 is concentrically and annularly disposed at an outer end portion of the directional key 11 and also outside of the movable electrode 20 and the fixed electrode 21. As shown in FIG. 3, the tilt direction changing member 30 may continuously be disposed on the whole surface in a circumferential direction, or may be disposed intermittently, that is, discontinuously.

The distance between the movable electrode 20 and the fixed electrode 21 changes with the depression of the directional key 11 in the arbitrary direction.

The movable electrode 20 is disposed on a backside of the key sheet 2 so as to move with the tilting of the center key 10 and the directional key 11. Specifically, the movable electrode 20 is disposed on the seat 7c on the back surface of the sheet-like member 7. The movable electrode 20 is formed into an annular shape.

For example, the movable electrode 20 is formed by printing or discharging a conductive rubber material, a conductive ink or the like onto the seat 7c of the sheet-like member 7. The movable electrode 20 may be formed using an appropriate metal thin film forming method such as evaporation coating or sputtering. The movable electrode 20 may be formed by, for example, forming a thin film of a metal or the like beforehand to attach the film by use of the adhesive, the binder or the like. It is to be noted that the movable electrode 20 preferably has flexibility so as to be deformable while the electrode comes into contact with the fixed electrode 21 and the linear ring electrode 22.

The movable electrode 20 may be formed into a shape other than the annular shape. A position of the movable electrode 20 may appropriately be changed as long as the electrode can move with the depression of the directional key 11. For example, the movable electrode 20 may be disposed at a position on the back surface of the center key 10 and around the presser member 8.

The movable electrode 20 has a slope with respect to the fixed electrode 21. The sheet-like member 7 is formed so that the seat 7c has a slope, and the movable electrode 20 is disposed on this seat 7c.

The movable electrode 20 and the fixed electrode 21 (specifically the divided fixed electrodes) constitute a capacitative element. In general, the capacitative element has a small electrostatic capacity value in a case where there is a large distance between the electrodes, and the value increases in a case where there is a small distance between the electrodes. Since the movable electrode 20 has the slope with respect to the fixed electrode 21, the distance between the movable electrode 20 and the fixed electrode 21 can be reduced, and an absolute value of the electrostatic capacity value can be increased.

In addition, in a case where the arbitrary direction of the depression of the directional key 11 is detected from the change of the electrostatic capacity or in a case where the strength and the speed of the force used in depressing the directional key 11 in the arbitrary direction are measured from the change of the electrostatic capacity, when the capacitative element has a large absolute value of the electrostatic capacity value, a high precision is easily obtained. Since the movable electrode 20 has the slope with respect to the fixed electrode 21, the distance between both of the electrodes can be reduced. In consequence, precisions of the detection of the direction and/or the measurement of the strength and/or the speed of the force can be improved.

The fixed electrode 21 is disposed so as to face the movable electrode 20. For example, the fixed electrode 21 which is annular shape is divided into four parts (the shapes may appropriately be changed) and disposed on the substrate 6 so as to face the movable electrode 20. This fixed electrode 21 is divided into four electrodes at equal intervals every 90 degrees in a circumferential direction.

The fixed electrode 21 is made of, for example, copper or the like. For example, The fixed electrode 21 may be formed by printing or discharging a conductive rubber material, a conductive ink or the like onto the substrate 6. The fixed electrode may be formed on the substrate 6 by an appropriate metal thin film forming method such as evaporation coating or sputtering. The fixed electrode 21 may be formed by, for example, forming a thin film of a metal or the like beforehand to attach the film by use of the adhesive, the binder or the like. It is to be noted that the fixed electrode 21 may be divided into a plurality of electrodes so that the direction can be detected, and divisions are not limited to four divisions. The electrodes may be divided into eight electrodes, sixteen electrodes or the like in accordance with various applications.

In the present example, it has been described that an interval between the adjacent fixed electrodes 21 is set to be comparatively small, but the interval may appropriately be broadened in accordance with the application or the like. The surface of each fixed electrode 21 is coated with an insulating layer (not shown) of Teflon (registered trademark), a resin film or the like. The insulating layer may be disposed on the surface of a portion of the movable electrode 20 which does not come into contact with the two linear ring electrodes 22. The insulating layer may be disposed on both of the movable electrode 20 (the surface of the portion of the movable electrode which does not come into contact with the two linear ring electrodes 22) and the fixed electrode 21. It is to be noted that even when the insulating layer is disposed on the movable electrode 20 or the fixed electrode 21, the movable electrode 20 or the fixed electrode 21 is referred in some case.

The two linear ring electrodes 22 function as two contacts for short-circuit, and are short-circuited when the electrodes come into contact with the movable electrode 20. The linear ring electrode 22 is annularly disposed on an inner side of the fixed electrode 21 in accordance with the shape of the movable electrode 20. The two linear ring electrodes 22 may be changed to another shape as long as the electrodes come into contact with the movable electrode 20 to short-circuit. The linear ring electrodes 22 may be changed to two contacts for short-circuit having a shape other than a linear shape.

The linear ring electrode 22 is made of, for example, copper or the like. For example The linear ring electrode 22 may be formed by printing or discharging a conductive rubber material, a conductive ink or the like onto substrate 6. The linear ring electrode 22 may be formed on the substrate 6 by use of an appropriate metal thin film forming method such as evaporation coating or sputtering. The linear ring electrode 22 may be formed by, for example, forming a thin film of a metal or the like beforehand to attach the film by use of the adhesive, the binder or the like.

On the movable electrode 20, a space 38 is disposed, for example, between the sheet-like member 7 and the back surface (the stepped surface 11bc) of the directional key 11. The space 38 is constituted by the stepped surface 11bc on the back surface of the directional key 11 and the upper surface of the sheet-like member 7. When the movable electrode 20 moves downwards, the movable electrode comes into contact with the fixed electrode 21 and the linear ring electrode 22. In consequence, the seat 7c is pushed up. The space 38 contains the seat 7c so that the movable electrode 20 smoothly comes into contact with the fixed electrode 21, and the space 38 gradually collapses.

A part of the stepped surface 11bb of the directional key 11 may be provided with air passages 40 which release air of the space 38 while the space 38 gradually collapses and which blow air into the space 38 when canceling the depressing operation in the arbitrary direction. In consequence, the directional key 11 is more smoothly operated.

A part of the support member 36 may be provided with air passage 41 which release air from the multidirectional input device 1 while the center key 10 and the directional key 11 tilt and which blow air into the multidirectional input device 1 when canceling the depressing operation of the directional key 11 in the arbitrary direction. In consequence, the center key 10 and the directional key 11 are is more smoothly operated.

FIG. 6(a) is a sectional view showing an initial state of the multidirectional input device 1 according to one example of the first embodiment of the present invention. FIGS. 6(b) to 6(e) are sectional views showing states of the multidirectional input device 1 according to one example of the first embodiment of the present invention in order in a case where the directional key 11 is depressed in the arbitrary direction (here, the rightward direction). FIG. 6(f) is a sectional view showing a state of the multidirectional input device 1 according to one example of the first embodiment of the present invention in a case where the center key 10 is depressed. It is to be noted that, in the multidirectional input device 1 shown in FIG. 6, dimensions and the like of the multidirectional input device 1 shown in FIG. 3(a) are changed for the sake of description. In FIG. 6, hatchings which show sections of the movable electrode 20, fixed electrodes 21a, 21c and two linear ring electrodes 22 are omitted.

When the right side of the directional key 11 is depressed, the operation is transmitted from the stepped surface 11ba of the directional key 11 to the flange 10a of the center key 10. In this case, the end portion of the flange 11a abuts on the lower surface 35ba of the upper portion 35b of the cover member 35 to form a tilt support of the center key 10 and the directional key 11. In consequence, the center key 10 tilts together with the directional key 11 (see FIG. 6(b)). It is to be noted that even when the directional key 11 is depressed in any direction, the keys similarly tilt to generate the feeling of click described later.

When the center key 10 and the directional key 11 tilt, the movable electrode 20 moves downwards and comes close to the substrate 6 to come into contact with the two linear ring electrodes 22, and electricity is conducted to the two linear ring electrodes 22 (see FIG. 6(b)). When the electricity is conducted to the two linear ring electrodes 22, an on-signal is obtained. When the movable electrode 20 comes into contact with the two linear ring electrodes 22, the electricity is conducted to the two linear ring electrodes 22 to generate the on-signal. When the movable electrode is detached from the two linear ring electrodes, this conducted state is cancelled. It is to be noted that the on-signal generated by the electric conduction is continuously generated during the operation of the directional key 11, that is, as long as the movable electrode 20 is brought into contact with the two linear ring electrodes 22.

This on-signal may be used as, for example, an excitation signal of the C/V conversion IC 201, the control unit or the whole system. Here, the control unit starts the detection of the direction in response to this on-signal. It is to be noted that even when a state shown in FIG. 6(a) is transferred to that shown in FIG. 6(b), the electrostatic capacity changes. Therefore, the arbitrary direction of the depression can be detected.

When the right side of the directional key 11 is further depressed, the center key 10 and the directional key 11 further tilt to allow the tilt direction changing member 30 to abut on the substrate 6 (see FIG. 6(c)). When the tilt direction changing member 30 abuts on the substrate 6, the tilt support of the center key 10 and the directional key 11 shifts to a position where the member abuts on the substrate.

As shown in FIGS. 6(b) and (c), when the center key 10 and the directional key 11 tilt, the presser member 8 moves downwards, but the small protrusion 8a is pushed and collapsed by the click feeling generating section 9. However, any force to deform the click feeling generating section 9 is not applied yet, the feeling of click is not generated.

The tilt direction changing member 30 abuts on the substrate 6, and the tilt support of the center key 10 and the directional key 11 shift onto the position where the member abuts on the substrate. Therefore, when the right side of the directional key 11 is further depressed, that is, when the directional key 11 is further depressed in the right direction as shown in FIGS. 6(c) and (d), the tilt direction of the center key 10 and the directional key 11 changes so that the key moves downwards in a direction (a left direction) opposite to the right direction (see FIG. 6(d)). It is to be noted that in this case, the center key 10 and the directional key 11 sometimes move downwards in parallel with each other on conditions such as a shape (a size, a width in a sectional direction, a length, etc.) and a material (a degree of deformation or whether or not the material is deformable) of the tilt direction changing member 30. In the present invention, even in such a case, it is described that the center key 10 and the directional key 11 tilt.

When the center key 10 and the directional key 11 tilt, the end portion of the flange 11a of the directional key 11 abuts on the lower surface 35ba of the upper portion 35b of the cover member 35 to constitute the tilt support of the directional key 11. Therefore, a force due to the tilting of the center key 10 and the directional key 11 is applied to this abutment portion to impose a burden on the portion. The upper portion 35b of the cover member 35 is sometimes raised owing to this burden, but the key moves downwards in the direction (the left direction) opposite to the right direction. In consequence, this burden can be reduced, and the upper portion 35b of the cover member 35 can be prevented from being raised.

When the center key 10 and the directional key 11 tilt, the presser member 8 moves downwards, but the small protrusion 8a is all collapsed by the click feeling generating section 9 (see FIG. 6(c)). Furthermore, a main body 8b of the presser member 8 presses the click feeling generating section 9 to apply such a force as to deform the click feeling generating section 9. Therefore, the click feeling generating section 9 is deformed (see FIG. 6(d)).

In consequence, the feeling of click is generated. At this time, electricity is conducted to the click feeling generating section 9 via a fixed contact (not shown) to generate the on-signal, but this signal may appropriately be used. For example, the processing in accordance with the arbitrary direction detected in response to this signal may be changed. For example, after the directional key 11 is depressed in the same direction (the right direction) to generate the feeling of click, the directional key cannot further be depressed in the same direction. Even in this case, if this operation is not cancelled, processing may be performed to move the pointer at the usual speed (basically the certain speed) before the generation of the feeling of click and accelerate and move the pointer after the generation of the feeling of click. Instead of using this signal, for example, the change of the electrostatic capacity generated before the generation of the feeling of click may be stored in a storage section or the like of the control unit beforehand to change the processing in accordance with the detected arbitrary direction with reference to this change of the electrostatic capacity.

Here, even in a case where the tilt direction changing member 30 is not disposed, when the directional key 11 is depressed in the right direction, the presser member 8 moves downwards. In consequence, the presser member 8 presses the click feeling generating section 9 to generate the feeling of click. The force required for depressing the directional key 11 in the arbitrary direction to generate the feeling of click depends on the force which deforms the click feeling generating section 9. Therefore, when the directional key 11 is depressed in the arbitrary direction, the feeling of click is quickly generated, and the operation of the directional key 11 before the generation of the feeling of click instantly ends in some case.

Therefore, the tilt direction changing member 30 may be disposed so that the force required for depressing the directional key 11 in the arbitrary direction to tilt the center key 10 and the directional key 11 is larger after the change of the tilt direction of the center key 10 and the directional key 11 than before the change of the tilt direction of the center key 10 and the directional key 11. In consequence, the force required for depressing the directional key 11 in the arbitrary direction to generate the feeling of click is larger than that in a case where the tilt direction changing member 30 is not disposed. Therefore, while the force is gradually applied, a generation point of the feeling of click can be displaced. In consequence, while the directional key 11 is depressed in the arbitrary direction, a region (a region of the operation of the directional key 11 before the generation of the feeling of click) of a predetermined small force (i.e., the force smaller than the force required for depressing the directional key in the arbitrary direction to generate the feeling of click) can be broadened. Therefore, the operator easily depress the directional key in the arbitrary direction before the generation of the feeling of click.

The tilt direction changing member 30 is disposed so that the force required for depressing the directional key 11 in the arbitrary direction to tilt the center key 10 and the directional key 11 is larger after the change of the tilt direction of the center key 10 and the directional key 11 than before the change of the tilt direction of the center key 10 and the directional key 11. This is realized by, for example, disposing the tilt direction changing member 30 at a position in a lateral direction where a distance from the upper surface (the portion where the depressing operation is to be performed) of the directional key 11 to the tilt direction changing member 30 is shorter than to a position of the tilt support before the change of the tilt direction of the center key 10 and the directional key 11 as shown in FIG. 6 and the like. Moreover, the tilt direction changing member 30 is disposed outside the upper surface of the directional key 11.

In a case where the right side of the directional key 11 is further depressed, the presser member 8 which deforms the click feeling generating section 9 then constitutes the tilt support, and the directional key further tilts to the right (see FIG. 6(e). This is because the tilt direction changing member 30 has elasticity (the member is deformable) .

It is to be noted that in this case, the center key 10 and the directional key 11 sometimes move downwards in parallel with each other or slightly move downwards even in a direction opposite to the right direction (the side reverse to the arbitrary direction), depending on conditions such as a shape (a size, a length, etc.) of the presser member 8, the shape (the size, the width in the sectional direction, the length, etc.) of the tilt direction changing member 30 and materials (degrees of deformations (degrees of the elasticity) or whether or not the materials are deformable) of the presser member and the tilt direction changing member. Even in such a case, in the present invention, it is described that the center key 10 and the directional key 11 tilt.

As described above, the multidirectional input device 1 is formed into a structure in which it is assumed that at least one of the tilt direction changing member 30 and the presser member 8 is deformable. While the directional key 11 is depressed in the arbitrary direction, the feeling of click is generated. Subsequently, the key is further depressed in the arbitrary direction, and then the tilt direction changing member 30 and/or the presser member 8 is deformed to further tilt the center key 10 and the directional key 11. In consequence, after the generation of the feeling of click, the center key 10 and the directional key 11 can tilt. Therefore, the movable electrode 20 can further come close to the fixed electrode 21. While the key is depressed in the same arbitrary direction, it is possible to detect the direction and/or measure the strength and/or the speed of the force from the change of the distance between the electrodes even after the generation of the feeling of click.

In a case where the presser member 8 and the tilt direction changing member 30 are made of the hard resin or the like, even when the key is further depressed in the same direction as the arbitrary direction of the depression, the key is not depressed in some case after the generation of the feeling of click.

As shown in FIGS. 6(b) to (e), the second bent portion 7b is developed. In consequence, the directional key 11 smoothly tilts.

As shown in FIGS. 6(b) to (e), the movable electrode 20 comes into contact with the fixed electrode 21a to thereby come close to the fixed electrode 21. In consequence, the distance between the movable electrode 20 and each of the divided fixed electrodes 21, that is, the distance between the movable electrode 20 and the fixed electrode 21 changes. Therefore, the electrostatic capacity between the movable electrode 20 and each of the divided fixed electrodes 21 changes. It is to be noted that the insulating layer is disposed on the surface of the movable electrode 20 and/or the fixed electrode 21. Therefore, even when the movable electrode 20 comes into contact with the fixed electrode 21, the electrostatic capacity can be measured.

As shown in FIGS. 6(b) to (e), the space 38 contains the seat 7c and gradually collapses.

When the operation of depressing the directional key 11 in the arbitrary direction is cancelled, the center key 10 and the directional key 11 returns to an initial state of FIG. 6(a) owing to the restoring forces of the developed second bent portion 7b and the expanded portions, which are to return to their original shapes (i.e., the restoring force due to the elasticity of the sheet-like member 7). The space 38 also returns to its original shape owing to the restoring force due to the elasticity of the sheet-like member 7.

Moreover, when the center key 10 is operated (depressed), the directional key 11 does not move. As shown in FIG. 6(f), the only directional key 11 moves downwards, and the presser member 8 of the center key presses and collapses the click feeling generating section 9 on the substrate 6. The electricity is conducted to the fixed contact (not shown) to generate the on-signal.

In addition, in a case where the sheet-like member 7 is not disposed, for example, a leaf spring or the like is disposed between the upper surface of the flange 11a and the lower surface 35ba of the upper portion 35b of the cover member 35. This leaf spring and the presser member 8 having the small protrusion 8a which abuts on the click feeling generating section 9 support the center key 10 and the directional key 11. In this case, it is preferable that an outer circumference surface 10c of the center key 10 abuts on an inner circumference surface 11c of the directional key 11.

The movable electrode 20 and the like are arranged on the back surface of the directional key 11 or the like. However, the movable electrode 20 is sometimes deformed as described above. Therefore, it is preferable that an underside of the directional key 11 is formed to be deformable (it is preferable to impart the elasticity having the restoring force) to dispose the movable electrode 20 on a lower surface of this directional key or that the seat 7c and the like are arranged in the same manner as described above to dispose the movable electrode 20 on this seat 7c. The tilt direction changing member 30 is also disposed at the end portion of the flange 11a of the directional key 11 integrally or disposed later by being secured using the adhesive, the binder or the like. The presser member 8 is directly formed integrally with the center key 10 on the back surface of the center key 10, or formed of any synthetic resin, a metal or the like separately from the center key 10 beforehand and then secured to the center key 10 by use of the adhesive, the binder or the like.

### (Second Embodiment)

FIG. 7 is a sectional view of a multidirectional input device 1A according to one example of a second embodiment. It is to be noted that hatching of sections are omitted from a movable electrode 20, fixed electrodes 21a, 21c, and two linear ring electrodes 22, and they are shown in black. The multidirectional input device is different from the above multidirectional input device 1 in that a tilt support of a center key 10 and a directional key 11 is disposed at a position of a presser member 80. That is, a portion where the presser member 80 abuts on a click feeling generating section 9 forms the tilt support, and the center key 10 and the directional key 11 tilt like a seesaw. The presser member 80 does not have any portion that corresponds to a small protrusion 8a.

In this case, when the directional key 11 is depressed in an arbitrary direction, a portion of the directional key 11 in an opposite direction moves upwards according to degree of depressing. Therefore, a space between an upper surface of a flange 11a and a lower surface 35ba of an upper portion 35b of a cover member 35 needs to be broadened.

For example, in a case where a tilt direction changing member 30 is disposed, a space between the upper surface of the flange 11a and the lower surface 35ba of the upper portion 35b of the cover member 35 needs to include a distance between a lower surface or an upper surface of the tilt direction changing member 30 and a substrate 6 or a key sheet 2 in an initial state.

Moreover, in a case where the tilt direction changing member 30 is not disposed, the space between the upper surface of the flange 11a and the lower surface 35ba of the upper portion 35b of the cover member 35 needs to be reduced. In consequence, when the directional key 11 is depressed in the arbitrary direction, the end portion of the flange 11a abuts on the lower surface 35ba of the upper portion 35b of the cover member 35, this abutment portion constitutes the tilt support of the center key 10 and the directional key 11, and the presser member 80 can deform the click feeling generating section 9.

In addition, when the tilt direction changing member 30 is not disposed, a burden is imposed on a portion which constitutes the tilt support and in which the end portion of the flange 11a abuts on the lower surface 35ba in the same manner as described above. In a case where the tilt direction changing member 30 is disposed, even when the directional key 11 is depressed in the arbitrary direction, an opposite side of the key do not move upwards according to degree of depressing. Therefore, the burden can be reduced, the space between the upper surface of the flange 11a and the lower surface 35ba of the upper portion 35b of the cover member 35 can be reduced, and the multidirectional input device 1 can be miniaturized.

Since description other than the above description conforms to the first embodiment, the description is omitted.

### (Third Embodiment)

FIG. 8 is a sectional view of a multidirectional input device 1B according to one example of a third embodiment. It is to be noted that in FIG. 8, hatchings of a movable electrode 20, fixed electrodes 21a, 21c and two linear ring electrodes 22 are omitted. The present embodiment is different from the first embodiment in that a slope of the movable electrode 20 inverted. That is, in the first embodiment, a section of the movable electrode 20 is substantially formed into an inverted " 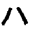 "-shape. However, in the third embodiment, a section of the movable electrode 20 is substantially formed into " 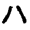 "-shape.

When a center key 10 and a directional key 11 tilt, the movable electrode moves. However, when the section of the movable electrode 20 is substantially formed into the inverted " 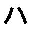 ", the movable electrode largely moves with the tilting. Therefore, since the electrostatic capacity largely changes, a precision in detecting a direction is improved.

It is to be noted that in the third embodiment, the slope of the movable electrode 20 is inverted, and a seat 82 and a space 81 are also formed in accordance with this inverted slope. Furthermore, in the third embodiment, two fixed contacts of the two linear ring electrodes 22 and the like are arranged outside the fixed electrode 21 in accordance with the slope of the movable electrode 20.

Since description other than the above description conforms to the first embodiment, the description is omitted.

### (Fourth Embodiment)

FIG. 9(a) is a sectional view of a multidirectional input device 1C according to one example of a fourth embodiment. FIG. 9(b) is a schematic sectional view showing a state of the multidirectional input device 1C according to one example of the fourth embodiment in a case where a directional key 11 is depressed and operated in an arbitrary direction. It is to be noted that in FIGS. 9(a) and (b), hatchings are omitted from a movable electrode 20, fixed electrodes 21a, 21c and two linear ring electrodes 22.

The present embodiment is different from the first embodiment in a space disposed above the movable electrode 20. That is, instead of a seat 7c disposed at a sheet-like member 7, as shown in FIG. 9(a), a slope portion 83 which imparts a slope to a fixed electrode 21 is formed at a predetermined position of the sheet-like member 7, and a space 84 corresponding to a space 38 of the first embodiment is disposed between this slope portion 83 and a back surface of the directional key 11.

When the directional key 11 is depressed in the arbitrary direction, as shown in FIG. 9(b), the movable electrode 20 comes into contact with the fixed electrode 21a, a slope portion 83 and a rising portion 88 is deformed, and the space 84 collapses. It is to be noted that the rising portion 88 may be provided with a through hole which is imparted to a function similar to that of an air passage 40 described above.

In the fourth embodiment, since the slope portion 83 is formed, a stepped surface 11bc does not have to be disposed on the back surface of the directional key 11, and a flat portion 85 can be disposed on the back surface of the directional key 11. Therefore, this flat portion 85 can variously be decorated. This is especially effective in a case where the directional key 11 has transmittance and is of an illuminative type.

Sections of a first bent portion 7a and a second bent portion 7b are substantially formed into a "⊐"-shape, and description thereof conforms to that of the first bent portion 7a and the second bent portion 7b of the first embodiment. Since description other than this description conforms to that of the first embodiment, the description is omitted.

### (Fifth Embodiment)

FIG. 10 is a sectional view of a multidirectional input device 1D according to one example of a fifth embodiment. It is to be noted that in FIG. 10, hatchings of a movable electrode 20 and fixed electrodes 21a, 21c are omitted.

The present embodiment is different from the first embodiment in that a movable electrode 20 and a fixed electrode 21 are arranged in parallel with each other. Even this case can be employed in the present invention as long as a change of an electrostatic capacity can be grasped by movement of the movable electrode 20. It is to be noted that in this case, the movable electrode 20 does not come into contact with the fixed electrodes 21a, 21c and the like in some case. In this case, two linear ring electrodes 22 and the insulating layer may appropriately be omitted.

Since description other than the above description conforms to the first embodiment, the description is omitted.

### (Others)

A part or a plurality of parts of the first to fifth embodiments may appropriately be changed, and the first to fifth embodiments may appropriately be combined.

It is to be noted that the fixed electrode 21 and the movable electrode 20 may appropriately be replaced with another fixed element and another movable element. In this case, a constituting element of the control unit is appropriately modified or omitted.

The fixed element and the movable element may be configured so that, when the directional key 11 is depressed in the arbitrary direction at least before the generation of the feeling of click, the distance between the fixed element and the movable element changes, and the arbitrary direction of the depression is detected from this change of the distance at least before the generation of the feeling of click.

Moreover, the movable element and the fixed element may be configured so that, when the directional key 11 is depressed in the arbitrary direction before the generation of the feeling of click, the distance between the elements changes, and the arbitrary direction of the depression is detected from this change of the distance before and after the generation of the feeling of click.

Furthermore, the movable element and the fixed element may be configured so as to further measure the strength and/or the speed of the force used in depressing the directional key in the arbitrary direction from the change of the distance.

Examples of a method of detecting the arbitrary direction of the depressed directional key 11 from the change of the distance between the fixed element and the movable element include a method in which a change of magnetism is used, a method in which a change of resistance is used and the like.

Examples of the method using the change of the magnetism include a method in which one of the movable element and the fixed element is a magnet, the other element is a wiring line for passing a current, and a direction is detected using a current generated in the wiring line owing to a change of a distance between the magnet and the wiring line. The strength and/or the speed of the force used in depressing the key may further be measured using this current.

Example of a method using a flow of current include a method in which a movable element and a fixed element are conductors, the elements are brought into contact with each other in a case where a directional key is depressed in an arbitrary direction, and the direction is detected from a relation between an area of this contact and values of resistances of the movable element and the fixed element. The strength and/or the speed of the force used in depressing the key can further be measured using this relation.

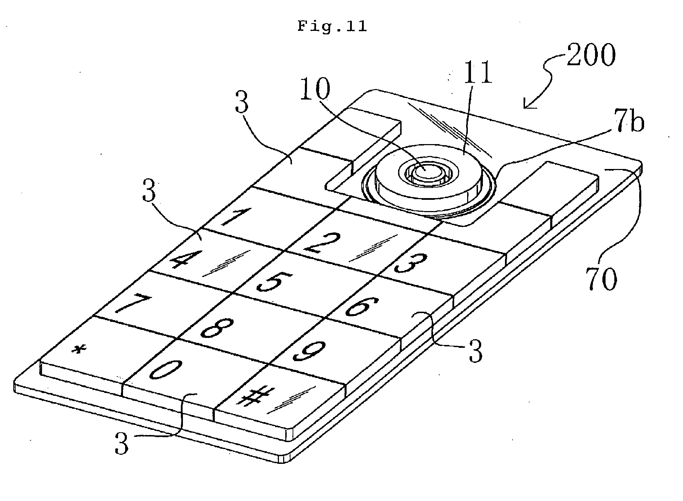

FIG. 11 is a perspective view of a key sheet 200 having a center key 10, a directional key 11 and a sheet-like member 70 on which these keys are arranged for use in a multidirectional input device according to one example of an embodiment of the present invention. The sheet-like member 70 corresponds to the sheet-like member 7, and the key sheet 200 corresponds to the key sheet 2.

According to the present invention, as in the key sheet 200, general keys 3 may be arranged on the sheet-like member 70 in addition to the center key 10 and the directional key 11. This invention may directly be used in an electronic device such as a cellular phone 5. In this case, the cover member 35 is a housing or the like of the electronic device. The substrate 6 corresponds to a substrate of the electronic device.

In this case, the electronic device itself the whole device in FIG. 1) may be grasped as the multidirectional input device.

## Claims

1. A multidirectional input device comprising:
a key sheet having a center key and a directional key which surrounds the center key;
a presser member disposed at a position corresponding to the center key on a back surface of the key sheet; and
a click feeling generating section which is disposed so as to face the presser member and which is deformed by the presser member to generate the feeling of click,
the multidirectional input device being formed into a structure in which the directional key tilts together with the center key with the depression of the directional key in an arbitrary direction,
and in which the click feeling generating section is deformed by the presser member to generate the feeling of click, as the directional key is depressed in the arbitrary direction,
the multidirectional input device further comprising:
a movable element and a fixed element configured so that a distance between the movable element and the fixed element changes with the depression of the directional key in the arbitrary direction at least before the generation of the feeling of click and so that the arbitrary direction of the depression is detected from the change of the distance at least before the generation of the feeling of click.

2. The multidirectional input device according to claim 1, wherein the movable element and the fixed element are configured so that the distance between the movable element and the fixed element changes with the depression of the directional key in the arbitrary direction before the generation of the feeling of click and so that the arbitrary direction of the depression is detected from this change of the distance before and after the generation of the feeling of click.

3. The multidirectional input device according to claim 1, wherein the movable element and the fixed element are configured so that the distance between the movable element and the fixed element changes with the depression of the directional key in the arbitrary direction before and after the generation of the feeling of click and so that the arbitrary direction of the depression is detected from this change of the distance before and after the generation of the feeling of click.

4. The multidirectional input device according to any one of claims 1 to 3, wherein the movable element and the fixed element are further configured so as to measure a strength and/or a speed of a force used in the depression of the arbitrary direction from the change of the distance.

5. The multidirectional input device according to any one of claims 1 to 4, wherein the key sheet further has a sheet-like member on which the center key and the directional key are arranged.

6. The multidirectional input device according to any one of claims 1 to 5, wherein the movable element is disposed on a backside of the key sheet so as to move with the tilting of the center key and the directional key, and the fixed element is disposed so as to face the movable element.

7. The multidirectional input device according to any one of claims 1 to 6, further comprising:
a tilt direction changing member which changes a tilt direction of the center key and the directional key so that the directional key moves downwards in a direction reverse to the arbitrary direction, as the directional key is depressed in the arbitrary direction,
wherein the click feeling generating section is deformed by the presser member to generate the feeling of click, as the directional key is further depressed in the arbitrary direction after the change of the tilt direction of the center key and the directional key.

8. The multidirectional input device according to claim 7, wherein the tilt direction changing member is disposed so that a force required for depressing the directional key in the arbitrary direction to tilt the center key and the directional key is larger after the change of the tilt direction than before the change of the tilt direction.

9. The multidirectional input device according to any one of claims 1 to 8, wherein at least one of the tilt direction changing member and the presser member can be deformed, and the tilt direction changing member and/or the presser member is deformed to further tilt the center key and the directional key, as the directional key is further depressed in the arbitrary direction after the generation of the feeling of click.

10. The multidirectional input device according to any one of claims 1 to 9, wherein the movable element has a slope with respect to the fixed element.

11. The multidirectional input device according to any one of claims 1 to 10, wherein the movable element is a movable electrode, the fixed element is a fixed electrode, and the distance between the movable element and the fixed element is an electrostatic capacity.

12. The multidirectional input device according to claim 11, further comprising:
a space disposed above the movable electrode; and
an insulating layer disposed on the surface of at least one of the movable electrode and the fixed electrode,
the device being configured so that, as the directional key is depressed in the arbitrary direction, with the tilting of the center key and the directional key, the movable electrode moves to come into contact with the fixed electrode via the insulating layer and so that, as the movable electrode comes into contact with the fixed electrode, the space gradually collapses.

13. The multidirectional input device according to claim 12, further comprising:
a space disposed above the movable electrode;
two contacts for short-circuit arranged on an inner side or an outer side of the fixed electrode; and
an insulating layer disposed on at least one of the surface of a portion of the movable electrode which does not come into contact with the two contacts for short-circuit and the surface of the fixed electrode,
the device being configured so that, as the directional key is depressed in the arbitrary direction, with the tilting of the center key and the directional key, the movable electrode moves to first short-circuit the contact for short-circuit and come into contact with the fixed electrode via the insulating layer and so that, as the movable electrode comes into contact with the fixed electrode, the space gradually collapses.

14. The multidirectional input device according to any one of claims 5 to 13, wherein a bent portion which is developed with the downward movement of the center key is further disposed in the sheet-like member at outer peripheral portions of the center key.

15. The multidirectional input device according to any one of claims 5 to 14, wherein a bent portion which is developed with the tilting of the directional key is further disposed in the sheet-like member at outer peripheral portions of the directional key.
